(19)

**Europäisches Patentamt**
**European Patent Office**
**Office européen des brevets**

(11) **EP 4 202 770 A1**

(12) **DEMANDE DE BREVET EUROPEEN**

(43) Date de publication:
**28.06.2023 Bulletin 2023/26**

(21) Numéro de dépôt: **22214809.0**

(22) Date de dépôt: **20.12.2022**

(51) Classification Internationale des Brevets (IPC):
**G06N 3/045** (2023.01)    **G06N 3/047** (2023.01)
**G06N 3/063** (2023.01)    **G06N 3/084** (2023.01)

(52) Classification Coopérative des Brevets (CPC):
**G06N 3/047; G06N 3/045;** G06N 3/063;
G06N 3/084

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**KH MA MD TN**

(30) Priorité: **24.12.2021 FR 2114471**

(71) Demandeur: **Commissariat à l'énergie atomique et aux énergies alternatives**
**75015 Paris (FR)**

(72) Inventeurs:
• **GUICQUERO, William**
  **38054 Grenoble Cedex 09 (FR)**
• **NGUYEN, Van-Thien**
  **38054 Grenoble Cedex 09 (FR)**

(74) Mandataire: **Cabinet Beaumont**
**4, Place Robert Schuman**
**B.P. 1529**
**38025 Grenoble Cedex 1 (FR)**

(54) **RESEAU DE NEURONES AVEC GENERATION A LA VOLEE DES PARAMETRES DU RESEAU**

(57) La présente description concerne un circuit comprenant :
- un générateur de nombres (205) configuré pour générer une séquence de vecteurs (207, 219) de taille m ;
- une mémoire (211) configurée pour stocker un ensemble de premiers paramètres ($\Omega$) d'un réseau de neurones auxiliaire (204) ;
- un dispositif de traitement configuré pour générer un ensemble de deuxièmes paramètres d'une couche (201) d'un réseau de neurones principal en appliquant plusieurs fois une première opération **(g),** par le réseau de neurones auxiliaire, réalisant une opération de génération à partir de chaque vecteur généré par le générateur de nombres, chaque génération délivrant un vecteur de deuxième paramètres, l'ensemble des vecteurs de deuxièmes paramètres constituant ledit ensemble de deuxièmes paramètres ; et dans lequel le nombre de deuxièmes paramètres est supérieur au nombre de premiers paramètres.

**Fig. 2A**

EP 4 202 770 A1

**Description**

Domaine technique

La présente description concerne de façon générale les réseaux de neurones artificiels et plus particulièrement la génération de paramètres d'un réseau de neurones profond par un circuit dédié à cette tâche.

Technique antérieure

Les réseaux de neurones artificiels (ANNs) sont des architectures informatiques développées pour imiter, dans une certaine mesure, le fonctionnement du cerveau humain.

Parmi les réseaux de neurones artificiels, les réseaux de neurones profonds (DNNs) sont formés d'une pluralité de couches dites cachées comprenant une pluralité de neurones artificiels. Chaque neurone artificiel d'une couche cachée est connecté aux neurones de la couche cachée précédente ou d'un sous-ensemble des couches précédentes par le biais de synapses généralement représentées par une matrice dont les coefficients représentent des poids synaptiques. Chaque neurone d'une couche cachée reçoit, en données d'entrées, des données de sortie générées par des neurones artificiels de la ou des couches précédentes et génère à son tour une donnée de sortie dépendant, entre autres, des poids connectant le neurone aux neurones de la ou des couches précédentes.

Les réseaux de neurones profonds sont des outils puissants et efficaces, en particulier lorsque leur nombre de couches cachées et de neurones artificiels est élevé. Cependant, l'utilisation de tels réseaux est limitée par la taille des mémoires et la puissance des dispositifs électroniques sur lesquels les réseaux sont implémentés. En effet, le dispositif électronique mettant en oeuvre un tel réseau doit être capable de contenir les poids et paramètres, ainsi qu'avoir une puissance de calcul suffisante, selon le fonctionnement du réseau.

Résumé de l'invention

Il existe un besoin de réduire les besoins en ressources (mémoire, puissance, etc.) d'un réseau de neurones profond implémenté dans un dispositif électronique.

Un mode de réalisation pallie tout ou partie des inconvénients des mise en oeuvre matérielle des réseaux de neurones profonds connus.

Un mode de réalisation prévoit un circuit comprenant :

- un générateur de nombres configuré pour générer une séquence de vecteurs de taille $m$, la séquence de vecteurs étant par exemple la même à chaque démarrage du générateur de nombre ;
- une mémoire configurée pour stocker un ensemble de premiers paramètres d'un réseau de neurones auxiliaire ;
- un dispositif de traitement configuré pour générer un ensemble de deuxièmes paramètres d'une couche d'un réseau de neurones principal en appliquant plusieurs fois une première opération, par le réseau de neurones auxiliaire, réalisant une opération de génération à partir de chaque vecteur généré par le générateur de nombres, chaque génération délivrant un vecteur de deuxième paramètres, l'ensemble des vecteurs de deuxièmes paramètres constituant ledit ensemble de deuxièmes paramètres ; et dans lequel le nombre de deuxièmes paramètres est supérieur au nombre de premiers paramètres.

Selon un mode de réalisation, la première opération est non-linéaire.

Selon un mode de réalisation, le circuit ci-dessus comprend en outre une mémoire volatile configurée pour stocker les vecteurs de la séquence de vecteurs.

Selon un mode de réalisation, le générateur de nombres est configuré pour stocker le premier vecteur dans une mémoire type registre, par exemple dans la mémoire volatile et pour générer un deuxième vecteur, dans lequel le deuxième vecteur est stocké dans la mémoire entraînant la suppression du premier vecteur.

Selon un mode de réalisation, le dispositif de traitement est en outre configuré pour réaliser une opération d'inférence à travers ladite couche du réseau de neurone principal en appliquant au moins une deuxième fonction à partir des deuxièmes paramètres et d'un vecteur d'entrée de ladite couche, l'opération d'inférence à travers la couche de neurones délivrant un vecteur de sortie, et dans lequel la taille $n_0$ du vecteur de sortie est supérieure à la taille $m$ d'un vecteur généré par le générateur de nombres.

Selon un mode de réalisation, le vecteur de sortie est généré, par la couche du réseau de neurones principal, coordonnée par coordonnée, par application d'au moins la deuxième fonction aux deuxièmes paramètres et au vecteur d'entrée.

Selon un mode de réalisation, le vecteur d'entrée est une image.

Selon un mode de réalisation, la couche du réseau de neurones principal est une couche dense.

Selon un mode de réalisation, la couche du réseau de neurones principal est une couche de convolution.

Selon un mode de réalisation, le générateur de nombres est une automate cellulaire.

Selon un mode de réalisation, le générateur de nombre est un générateur de nombres pseudo-aléatoires.

Selon un mode de réalisation, le générateur de nombre est un registre à décalage à rétroaction linéaire.

Un mode de réalisation prévoit un compilateur mis en oeuvre par ordinateur par un outil de conception de circuit comme ci-dessus, le compilateur recevant une description topologique d'un circuit, la description topologique précisant la première et deuxième fonction ainsi que la configuration du générateur de nombres, le compilateur étant configuré pour déterminer si la première opération est linéaire ou non-linéaire, et si la première opération est non-linéaire, le compilateur étant configuré pour générer un fichier de conception d'un circuit comme ci-dessus.

Selon un mode de réalisation, le compilateur est configuré pour effectuer, dans le cas où la première opérations est linéaire, la conception d'un circuit de sorte que le circuit mette en oeuvre une décomposition d'opérations en appliquant séquentiellement une troisième opération et une quatrième opération équivalente à la combinaison de la première opération et la deuxième opérations, la troisième opération prenant comme variables d'entrée le vecteur d'entrée et les premiers paramètres et la quatrième opération prenant en entrée la séquence de vecteurs générés par le générateur de nombres et la sortie de la troisième opération et délivrant ledit vecteur de sortie.

Un mode de réalisation prévoit un procédé de conception par ordinateur d'un circuit ci-dessus, comprenant, préalablement à la mise en oeuvre d'un compilateur comme ci-dessus, la mise en oeuvre d'un procédé de recherche de topologie optimale de réseaux de neurones principal et/ou génératif, et délivrant lesdites données de description topologique audit compilateur.

Un mode de réalisation prévoit un procédé de traitement de données comprenant, pendant une phase d'inférence :

- la génération d'une séquence de vecteurs de taille $m,$ par un générateur de nombres, la séquence de vecteurs étant la même à chaque démarrage du générateur de nombre ;
- le stockage d'un ensemble de premiers paramètres d'un réseau de neurones auxiliaire dans une mémoire ;
- la génération, par un dispositif de traitement, d'un ensemble de deuxièmes paramètres d'une couche d'un réseau de neurones principal en appliquant plusieurs fois une première opération, par le réseau de neurones auxiliaire, réalisant une opération de génération à partir de chaque vecteur généré par le générateur de nombres, chaque génération délivrant un vecteur de deuxième paramètres,

l'ensemble des vecteurs de deuxièmes paramètres constituant ledit ensemble de deuxièmes paramètres ; et dans lequel le nombre de deuxièmes paramètres est supérieur au nombre de premiers paramètres.

Selon un mode de réalisation, le procédé ci-dessus comprend en outre, une phase d'apprentissage du réseau de neurones auxiliaire, préalable à la phase d'inférence, la phase d'apprentissage comprenant l'apprentissage d'une matrice de poids, sur la base de la séquence de vecteurs générée par le générateur de nombres, la séquence de vecteurs étant identique à la séquence de vecteurs générée dans l'étape d'inférence.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 illustre un exemple d'une couche d'un réseau de neurones profond ;

la figure 2A illustre un exemple d'implémentation d'une couche dense d'un réseau de neurones profond selon un mode de réalisation de la présente description ;

la figure 2B illustre un autre exemple d'implémentation d'une couche dense d'un réseau de neurones profond selon un mode de réalisation de la présente description ;

la figure 2C illustre un exemple d'implémentation d'un réseau de neurones auxiliaire selon un mode de réalisation de la présente description ;

la figure 3 illustre un autre exemple d'implémentation d'une couche dense d'un réseau de neurones profond selon un mode de réalisation de la présente description ;

la figure 4 illustre un exemple de modèle d'un réseau de neurones profond comportant des couches denses comme illustrées en figures 2A, 2B ou 3 ;

la figure 5 illustre un exemple d'implémentation d'une couche de convolution d'un réseau de neurones profond selon un mode de réalisation de la présente description ;

la figure 6 illustre un autre exemple d'implémentation d'une couche de convolution d'un réseau de neurones profond selon un mode de réalisation de la présente description ;

la figure 7 est un exemple de modèle d'un réseau de neurones profond comportant des couches de convolution comme illustrées en figure 5 ou 6 ;

la figure 8 est un schéma par bloc illustrant une implémentation d'un compilateur configuré pour générer une conception de circuit ;

la figure 9 est un schéma par bloc illustrant une implémentation d'un outil de recherche automatique d'architecture neuronale selon un mode de réalisation de la présente description ; et

la figure 10 illustre un système matériel selon un exemple de mode de réalisation de la présente description.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les méthodes d'apprentissage, ainsi que le fonctionnement, d'un réseau de neurones ne sont pas décrits en détail et sont à la portée de la personne du métier.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

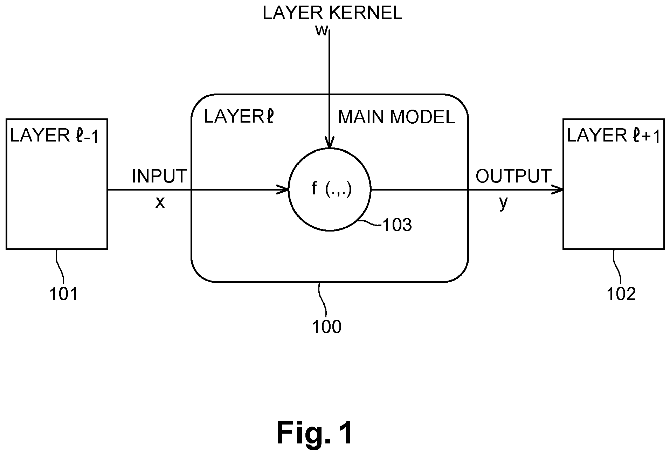

La figure 1 représente un exemple d'une couche 100 (LAYER l, MAIN MODEL) d'un réseau de neurones profond.

La couche 100 prend comme donnée d'entrée un objet $x$ (INPUT$x$), par exemple un vecteur, et génère, à partir de cette donnée d'entrée une donnée de sortie $y$ (OUTPUT). La donnée de sortie $y$ est par exemple un vecteur de taille identique ou différente du vecteur d'entrée $x$.

Le réseau de neurones profond comportant la couche 100 comprend par exemple une couche 101 (LAYER l-1) alimentant la couche 100 et/ou une couche 102 (LAYER l+1) alimentée par la couche 100. Bien que l'exemple de la figure 1 illustre une couche 100 alimentée par une couche précédente et alimentant une couche suivante, la personne du métier saura adapter à d'autres modèles, notamment à des modèles dans lesquels la couche 100 est alimentée par une pluralité de neurones appartenant à une pluralité d'autres couches et/ou alimente, une pluralité de neurones appartenant à une pluralité d'autres couches. La couche 101 est par exemple une couche d'entrée du réseau de neurones profond et génère, à partir d'une donnée d'entrée (non illustrée) du réseau, la donnée $x$ qui est ensuite fournie à la couche 100. La couche 102 est par exemple une couche de sortie du réseau de neurones et génère une donnée de sortie à partir de la donnée de sortie $y$ générée par la couche 100. A titre d'exemple, le nombre de neurones composants les couches 101 et 102 est inférieur au nombre de neurones composant la couche 100. Dans d'autres exemples, le réseau de neurones comporte d'autres couches de neurones supplémentaires avant et/ou après les couches 100, 101 et 102, ou ne comporte que la couche 100.

La couche 100 est par exemple une couche dense, c'est-à-dire que chacun des neurones artificiels la composant sont connectés à chacun des neurones artificiels composant la couche précédente ainsi qu'à chacun des neurones composant la couche suivante. Dans d'autres exemples, la couche 100 est une couche de convolution, une couche dense ou autre type de couche reliée à des synapses présentant un poids. Le réseau de neurones comporte généralement plusieurs types de couches.

La couche 100 effectue une opération de couche 103 ($f(.,.)$) prenant en entrée par exemple la donnée d'entrée $x$ et une matrice de poids $W$ (LAYER KERNEL) afin de générer la donnée de sortie $y$. A titre d'exemple, lorsque la couche 100 est une couche dense, l'opération 103 consiste en l'application d'une fonction mathématique quelconque, telle que par exemple :

[Math 1]

$$f(W, x) = Wx.$$

De manière générale, la nature de l'opération 103 dépend du type de la couche 100 ainsi que de son rôle dans le fonctionnement et l'utilisation du réseau de neurones. De manière générale, l'opération de couche 103 *l* comprend une première opération linéaire, entre deux tenseurs, qui peut se ramener à une opération multiplicative entre une matrice et un vecteur, éventuellement suivie d'une deuxième fonction, linéaire ou non linéaire.

Le stockage de la matrice de poids *W,* ainsi que des matrices similaires associées aux autres couches, est généralement réalisé par une mémoire. Toutefois, les matrices de poids étant de relativement grande taille, leur stockage est couteux en espace mémoire.

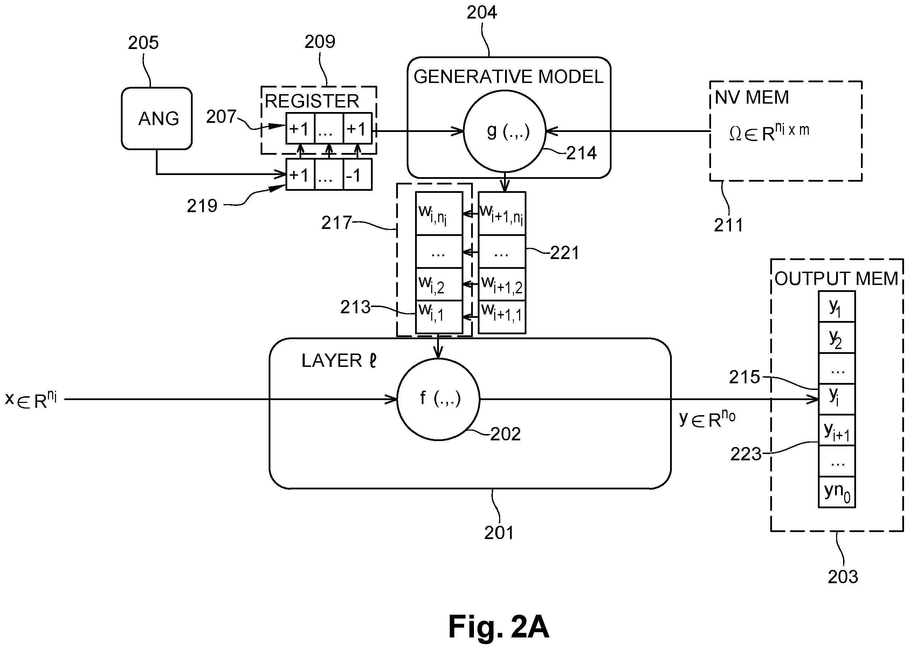

La figure 2A représente un exemple d'implémentation matérielle d'une couche dense d'un réseau de neurones profond selon un exemple de réalisation de la présente description.

En particulier, la figure 2A illustre un réseau de neurones profond comprenant une couche dense 201 (LAYER l) configurée pour générer des données de sortie *y* en appliquant une opération de couche 202 (*f*(.,.)) sur des données d'entrée *x* et des poids *W*. A titre d'exemple, les données d'entrée $x \in R^{n_i}$ de la couche 201 forment un vecteur de taille $n_i$ et les données de sortie $y \in R^{n_0}$ de la couche 201 forment un vecteur $(y_1, y_2, \cdots, y_i, y_{i+1}, \cdots, y_{n_0})$ de taille $n_0$. Dans certains cas, les données de sortie *y* sont stockées dans une mémoire (OUTPUT MEM) volatile ou non-volatile 203. A titre d'exemple, lorsque les données de sortie *y* sont fournies comme données d'entrée à une ou plusieurs couches suivantes, leur stockage est effectué de manière volatile et la mémoire 203 est par exemple un registre. La matrice des poids *W* permettant la génération des $n_0$ coordonnées du vecteur *y* serait alors de taille $n_i$ par $n_0$.

Dans les modes de réalisation décrits, au lieu de stocker la matrice des poids *W* dans une mémoire, on prévoit l'implémentation d'un réseau de neurones génératif auxiliaire 204 (GENERATIVE MODEL) pour générer les poids *W* colonne par colonne ou ligne par ligne.

Le réseau auxiliaire 204 est par exemple un auto-encodeur de type U-net, ou tout autre type de réseau génératif. En outre, le réseau auxiliaire 204 est relié à un circuit générateur de nombres 205 (ANG) tel que, par exemple, un générateur de nombres pseudo-aléatoires ou un automate cellulaire.

Le générateur de nombres 205 est configuré pour générer des vecteurs de taille *m,* où *m* est un entier strictement inférieur à $n_0$. Selon un mode de réalisation, un vecteur $\rho_i$ 207 est généré par le générateur 205 et est par exemple stocké dans un registre 209 (REGISTER). Le vecteur 207 est alors fourni au réseau auxiliaire 204. Le réseau auxiliaire 204 reçoit en outre une matrice $\Omega \in R^{n_i \times m}$ de taille $n_i$ par *m,* par exemple stockée dans une mémoire non-volatile 211 (NV MEM). La matrice $\Omega$ est une matrice de poids pour le réseau auxiliaire 204, cette matrice $\Omega$ ayant été préalablement apprise.

Dans des modes de réalisation, le circuit générateur de nombre 205, par exemple un générateur de nombres pseudo-aléatoires, est implémenté dans ou proche de la mémoire 211. La mémoire 211 est par exemple une matrice mémoire SRAM (de l'anglais "static random access memory" : mémoire à accès aléatoire). L'implémentation proche ou dans la matrice mémoire 211 permet d'effectuer les calculs directement dans la mémoire 211 (en anglais « In Memory Computing ») ou proche de la mémoire 211 (en anglais « Near Memory Computing »). Les nombres sont alors générés, par exemple sur la base d'une ou plusieurs valeurs stockées à des premières adresses de la mémoire, et stockés à des deuxièmes adresses de la mémoire, sans passer par un bus de données reliant la mémoire à des circuits externes de la mémoire. Par exemple, le générateur de nombres 205 est un registre à décalage à rétroaction linéaire, (LFSR, de l'anglais « Linear feedback shift register ») qui est implémenté dans ou proche de la matrice mémoire 211.

Les différentes implémentations possibles d'un générateur de nombres sont connues et sont à la portée de la personne du métier.

Selon un mode de réalisation, le générateur de nombres 205 est configuré pour générer, à chaque démarrage, toujours la même séquence de vecteurs. Autrement dit, le réseau de neurones auxiliaire 204 manipule toujours la même séquence de vecteurs. A titre d'exemple, si le générateur de nombres 205 est un générateur de nombres pseudo-aléatoires, la graine utilisée est une valeur fixe et, par exemple, stockée dans la mémoire 211.

Selon un mode de réalisation, lors d'une phase d'apprentissage du réseau de neurones auxiliaire 204, la séquence de vecteur utilisée, par exemple pour l'apprentissage de la matrice $\Omega$, est la même séquence que celle utilisée, par la suite, dans les opérations d'inférence et afin de générer les poids *W*.

Selon un mode de réalisation, les vecteurs constituant la séquence de vecteurs sont générés de sorte que la corrélation entre les vecteurs soit relativement faible, et de préférence minimale. En effet, la corrélation entre deux vecteurs $\rho_i$ et $\rho_j$, $1 \leq i,j \leq n_0$, induit une corrélation entre les sorties $y_i$ et $y_j$. A titre d'exemple, l'initialisation, ou le choix de la graine, du générateur de nombres 205 est réalisée afin d'introduire le moins de corrélation possibles entre les vecteurs de la séquence de vecteur. L'initialisation d'un générateur de nombre est connue par la personne du métier qui saura donc configurer le générateur de nombres 205 de sorte à réduire ou minimiser toute corrélation dans la séquence de vecteurs.

Selon un mode de réalisation, le réseau auxiliaire 204 génère un vecteur de sortie $W_i = (W_{i,1}, W_{i,2}, \cdots, W_{i,ni})$ de taille $n_i$ en appliquant une fonction ou un noyau 214 $g(.,.)$ prenant en variables la matrice $\Omega$ et le vecteur généré 207 $\rho_i$. A titre d'exemple, la fonction $g$ est linéaire et correspond à la multiplication $\Omega\rho_i$. Dans un autre exemple, une fonction non linéaire, par exemple une fonction d'activation $\sigma$, est appliquée en sus à la valeur $\Omega\rho_i$. Un exemple de fonction $g$ non-linéaire est définie par $g(\Omega,\rho) = \sigma(\Omega\rho)$ où $\sigma$ est elle-même une fonction non-linéaire telle que, par exemple, $\sigma(u) = u1_{[0,1]}(u)$ avec $1_{[0,1]}(.)$ la fonction indicatrice de l'intervalle [0,1].

De manière générale, on dira par la suite de la fonction $g$ qu'elle est linéaire si elle est cascadée par une fonction $\sigma$ linéaire, telle que par exemple la fonction identité. Autrement dit, la fonction $g$ est linéaire si $g(\Omega,\rho) = \lambda\Omega\rho$, où $\lambda$ est un nombre réel, et non-linéaire si $g(\Omega,\rho) = \sigma(\Omega\rho)$, avec $\sigma$ non-linéaire. De manière similaire, on dira de $f$ qu'elle est linéaire ou non-linéaire sous les mêmes conditions.

Le vecteur de sortie $W_i$ est alors par exemple stocké temporairement dans une mémoire, par exemple un registre 217. Le vecteur $W_i$ est ensuite transmis à la couche dense 201 du réseau de neurones profond qui applique l'opération de couche 202 $f(.,.)$ au vecteur $W_i$ et au vecteur d'entrée $x$ afin d'obtenir la i-ème coordonnée 215 $y_i$ du vecteur de sortie $y$. Ainsi, on a la relation :

[Math 2]

$$y_i = f\big(g(\Omega, \rho_i), x\big).$$

Suite à la génération de la coordonné $y_i$ 215, le générateur de nombres 205 génère un nouveau vecteur $\rho_{i+1}$ 219 qui est alors par exemple stocké dans le registre 209 écrasant le vecteur $\rho_i$ 207 précédemment généré. Le nouveau vecteur $\rho_{i+1}$ 219 est alors transmis au réseau auxiliaire 204 afin de générer un nouveau vecteur 221 $W_{i+1} = (W_{i+1,1}, W_{i+1,2}, \cdots, W_{i+1,ni})$. La génération du vecteur 221 s'effectue en appliquant la même fonction $g$ au vecteur $\rho_{i+1}$ 219 et à la matrice $\Omega$. Le vecteur $W_{i+1}$ 221 est alors par exemple stocké dans le registre 217, écrasant par exemple le vecteur $W_i$ 213.

Le vecteur $W_{i+1}$ 221 est ensuite transmis à la couche 201 du réseau de neurones profond, qui génère la i+1-ème coordonnée $y_{i+1}$ 223 du vecteur de sortie $y$ en appliquant l'opération 202 au vecteur $W_{i+1}$ 221 ainsi qu'au vecteur d'entrée x. A titre d'exemple, lorsque la fonction $g$ est définie par $g(\Omega,\rho) = \sigma(\Omega\rho)$ et lorsque la fonction $f$ est définie par $f(W,x) = W^T x$, où $W^T$ représente la matrice transposée de $W$, le vecteur de sortie $y$ est représenté par :

[Math 3]

$$y = \begin{bmatrix} \sigma(\Omega\rho_1)^T \\ \vdots \\ \sigma\big(\Omega\rho_{n_0}\big)^T \end{bmatrix} x.$$

Chacune des $n_0$ coordonnées du vecteur de sortie $y$ est ainsi générée sur la base du vecteur d'entrée $x$ de taille $n_i$ et d'un vecteur de taille $n_i$. Cela permet que seule la matrice $\Omega$ soit stockée de manière non-volatile, et sa taille est inférieure à $n_i \times n_0$, dans la mesure où m est inférieur à $n_0$. La matrice de poids pour la couche dense 201 est générée ligne par ligne à partir de la matrice $\Omega$ contenant $mn_i$ coefficients. Chaque ligne de poids est de préférence supprimée, ou autrement dit pas conservée en mémoire (dans le registre 217) suite à son utilisation pour la génération de la coordonnée du vecteur de sortie $y$ correspondante, afin de limiter l'usage de la mémoire le plus possible. Le taux de compression $CR$ de ce mode de réalisation est alors égal à $\dfrac{mn_i}{n_i n_0} = \dfrac{m}{n_0}$. Le taux de compression $CR$ est d'autant plus bas que m est petit devant $n_0$.

Dans le mode de réalisation décrit précédemment, les vecteurs $W_i$ successifs fournis en sortie du modèle génératif correspondent en pratique aux lignes de la matrice $W^T$. Chaque nouveau vecteur $W_i$ permettant le calcul d'une valeur $y_i$ implique de réaliser $n_i$ opérations de MAC (de l'anglais « Multiplication ACumulation ». Une opération de MAC correspond généralement à la réalisation d'une multiplication et d'une « accumulation » équivalent en pratique à une addition. En pratique, le calcul d'une valeur $y_i$ peut être réalisé par un dispositif de calcul MAC élémentaire capable de faire une opération de multiplication entre deux opérandes d'entrée et de sommer le résultat avec une valeur présente dans un registre et de mémoriser le résultat de sommation dans ce même registre (d'où l'accumulation). Ainsi, si on dispose d'un calculateur MAC élémentaire, le calcul d'une valeur $y_i$ nécessite de faire successivement $n_i$ opérations dans ce MAC élémentaire. Un avantage d'une telle solution est qu'elle permet d'utiliser un dispositif de calcul très compact du point de vue matériel, en acceptant de faire un compromis sur la vitesse de calcul si besoin.

Selon une variante de réalisation, les vecteurs $W_i$ successifs correspondent aux colonnes de la matrice $W^T$. Dans ce cas, les valeurs $(y_1, y_2, \cdots, y_i, y_{i+1}, \cdots, y_{n_0})$ peuvent alors être calculées en parallèle en utilisant $n_0$ calculateurs MAC. Chaque nouveau vecteur $W_i$ alimentant ainsi le calcul d'une opération de MAC dans chaque calculateur MAC. Un avantage de cette solution est qu'elle permet de réaliser plus rapidement ($n_0$ fois plus rapidement) les opérations de calculs MAC au global, au prix d'un matériel plus conséquent. Le besoin en mémoire, notamment pour les vecteurs $W_i$ reste identique au mode de réalisation précédent.

Selon une autre variante de réalisation, les vecteurs $W_i$ successivement délivrés par le modèle génératif 204 sont temporairement mémorisés dans une mémoire permettant de tous les intégrer. Le calcul des valeurs $(y_1, y_2, \cdots, y_i, y_{i+1}, \cdots, y_{n_0})$ est alors réalisé en « une fois » par exemple à l'aide d'un accélérateur matériel dédié à ce type d'opérations (produit matriciel, matrice $\times$ vecteur). Cet accélérateur matériel pourra éventuellement être prévu pour intégrer les autres dispositifs et étapes de procédé de la présente invention, par exemple en intégrant la mémoire mémorisant la matrice $\Omega$, en intégrant les moyens de calcul permettant de mettre en oeuvre le modèle génératif, et/ou en intégrant le générateur de nombres aléatoires.

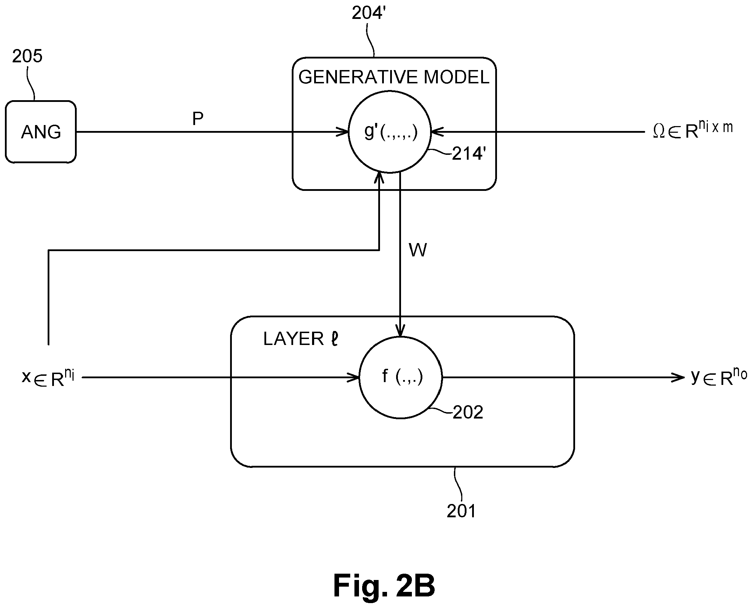

La figure 2B illustre un autre exemple d'implémentation d'une couche dense d'un réseau de neurones profond selon un mode de réalisation de la présente description. En particulier, le réseau de neurones profond est similaire à celui représenté dans la figure 2A, à l'exception que le réseau de neurones auxiliaire 204 est remplacé par un réseau de neurone auxiliaire 204' configuré pour appliquer une fonction ou un noyau 214' $g'(.,.,.)$. La fonction ou noyau 214' prend en entrée le vecteur d'entrée $x$, en plus des variables de la matrice $\Omega$, et le réseau de neurones auxiliaires 204' est donc un réseau dynamique. _En effet, la matrice $W$ générée par le réseau de neurones auxiliaire 204' dépend du vecteur d'entrée $x$ tandis que les vecteurs $\rho_i$ modélisent une information à priori sur les paramètres de la matrice $W$. Les opérations sur le vecteur d'entrée $x$ permettent de prendre en compte les propriétés du vecteur d'entrée $x$ et d'ajuster de façon dynamique le comportement de la couche 201 à travers la matrice $W$. Contrairement à la fonction ou noyau 214, la fonction ou noyau 214' prend en entrée les $n_0$ vecteurs $\rho_1$ à $\rho_{n_0}$, tous de taille $m$. A titre d'exemple, les $n_0$ vecteurs sont concaténés sous la forme d'une matrice $P$ de taille $n_0 \times m$. La sortie du réseau de neurones auxiliaire 204' est alors une matrice W de taille $n_0 \times n_i$. La matrice W générée est ensuite par exemple transmise à la couche dense 201 du réseau de neurones profond qui applique une opération de couche à la matrice $W$ et au vecteur d'entrée $x$ afin de générer un vecteur de sortie $y$ de taille $n_0$. A titre d'exemple, la matrice $W$ est fournie à la couche 201 colonne par colonne.

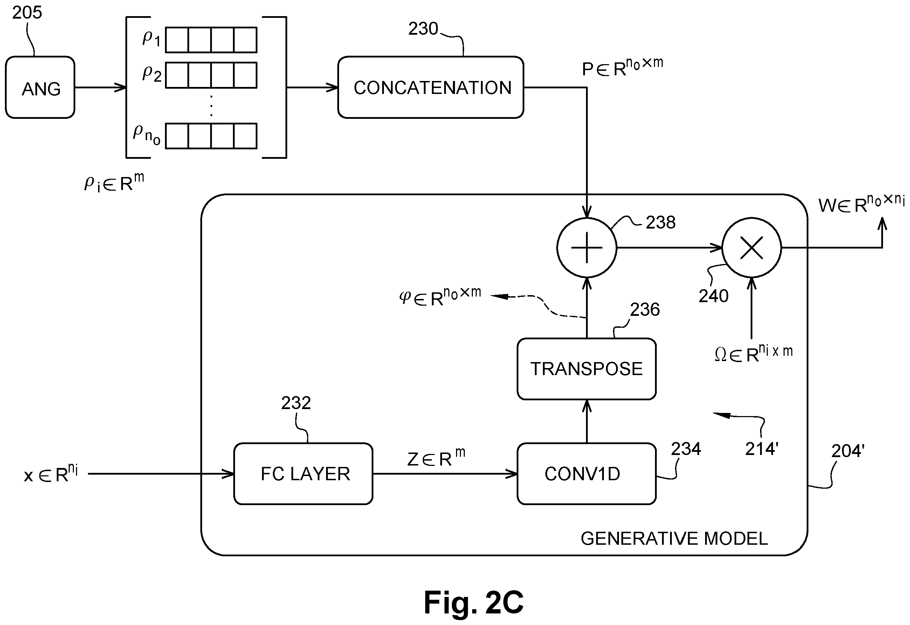

La figure 2C illustre un exemple d'implémentation d'un réseau de neurones auxiliaire dynamique 204'.

A titre d'exemples, les vecteurs $\rho_1$ à $\rho_{n_0}$ sont concaténés (CONCATENATION), par exemple dans un registre 230. La concaténation résulte en une matrice P de taille $n_0 \times m$. Selon un mode de réalisation, le vecteur d'entrée $x$ de taille $n_i$ est fourni au réseau 204' et plus particulièrement à une couche 232 (FC LAYER) du réseau 204'. A titre d'exemple, la couche 232 est une couche complètement connectée. La couche 232 est configuré pour générer un vecteur $z \in R^m$ de taille $m$, sur la base du vecteur d'entrée $x$. Le vecteur z est ensuite transmis à une couche 234 (CONV1D) de convolution unidimensionnelle. L'opération de convolution unidimensionnelle génère par exemple $n_0$ canaux de sortie. A titre d'exemple, la convolution unidimensionnelle comprend en outre l'addition de chaque séquence de vecteurs $\rho_i$ avec un canal de sortie $i$, $i \in \{1, \cdots, n_0\}$. Ainsi, la matrice $W$ est fournie colonne par colonne à la couche 201. A titre d'exemple, la couche 234 applique $n_0$ filtres de convolution, chaque filtre étant de taille k sur le vecteur d'entrée $x$, $k$ étant par exemple un paramètre correspondant à la taille des filtres, ou fenêtres, utilisés lors de l'opération de convolution unidimensionnelle. A titre d'exemple, la valeur de $k$ est inférieure à la valeur de $n_0$. A titre d'exemple, $k$ est égal à 3 ou 5 ou 7 ou 9 ou 11, etc. La couche 234 génère un tenseur à deux dimensions et de taille $m \times n_0$ qui est par exemple transposé, par exemple par une opération 236 (TRANSPOSE), afin d'obtenir un tenseur à deux dimensions $\varphi$ de même taille que la matrice $P$, c'est à dire de taille $n_0 \times m$.

La matrice P est par exemple transmise au réseau 204' et est ajouté au tenseur $\varphi$, par exemple par un additionneur 238. La sortie de l'additionneur 238 est par exemple fournie à un circuit 240 configuré pour mettre en oeuvre une opération multiplicative. Le circuit 240 reçoit en outre la matrice des poids $\Omega$ et génère alors la matrice $W$. A titre d'exemple, le circuit 240 est implémenté dans, ou proche, de la mémoire 211 dans laquelle la matrice $\Omega$ est stockée.

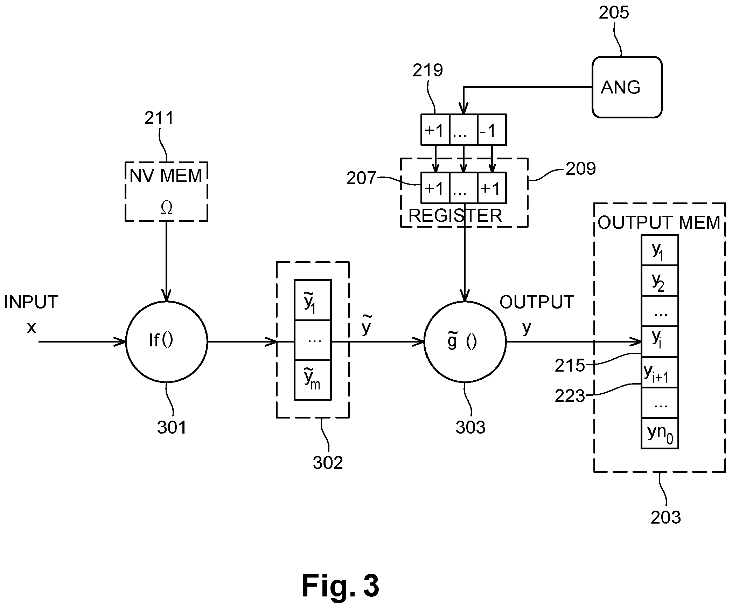

La figure 3 illustre un exemple d'implémentation d'un réseau de neurones profond selon un autre mode de réalisation pouvant être utilisé dans un procédé de conception selon la présente description. En particulier, la figure 3 illustre un exemple d'implémentation lorsque les deux opérations ou noyaux $f$ et $g$ sont entièrement linéaires, autrement dit la fonction d'activation $\sigma$ appliquée au résultat de la multiplication matricielle est elle-même linéaire, comme par exemple la fonction identité. Dans l'exemple où la fonction $\sigma$ est la fonction identité, l'ordre des opérations $g$ et $f$ peut être interverti. En effet, dans ce cas on a la relation :

[Math 4]

$$y = \begin{bmatrix} \rho_1^T \\ \vdots \\ \rho_{n_0}^T \end{bmatrix} \Omega^T x.$$

Dans cette formulation, le vecteur d'entrée *x* est tout d'abord compressé vers un vecteur de dimension *m* en lui appliquant une fonction 301 *lf*, dont une variable est la matrice $\Omega$, et qui est définie par $lf(\Omega, x) = \Omega^T x$. Le résultat de l'opération 301 sur la donnée d'entrée *x* est un vecteur $\tilde{y} = (\tilde{y}_1, \cdots, \tilde{y}_m)$ de taille m et est par exemple stocké temporairement dans une mémoire 302. Le vecteur $\tilde{y}$ est ensuite projeté de manière séquentielle par les $n_0$ vecteurs de taille *m* générés par le générateur de nombres 205 afin d'obtenir la donnée de sortie *y*. Autrement dit, une fois le vecteur $\tilde{y}$ obtenu, le générateur de nombres 205 génère le vecteur $\rho_i$ 207, et la i-ème coordonnée 215 $y_i$ du vecteur de sortie y est obtenue en appliquant une opération 303 $\tilde{g}$ définie par $\tilde{g}(\rho_i, \tilde{y}) = \rho_i^T \tilde{y}$. La i+1-ème coordonnée $y_{i+1}$ 223 du vecteur *y* est ensuite obtenue de la même manière, à partir du nouveau vecteur 219 $\rho_{i+1}$ généré par le générateur 205.

Le nombre de MACs (de l'anglais « Multiplication ACumulation ») utilisés pour le fonctionnement d'une couche dense standard est de $n_0 n_i$. Le nombre de MACs utilisés pour le fonctionnement de la couche dense 201 décrite en relation avec la figure 2A vaut par exemple $n_0 m n_i + n_i n_0$, ce qui est supérieur au nombre de MACs d'une couche dense standard. Le terme supplémentaire $n_i n_0$ est dû au réseau auxiliaire 204. Cependant, le nombre de MACS est réduit à $m n_i + m n_0$ lorsque l'opération *g* est cascadée par une fonction d'activation linéaire et lorsque l'implémentation décrite en relation avec la figure 3 est mise en oeuvre. Le ratio *MR* entre le nombre de MACs utilisés par l'implémentation décrite en relation avec la figure 3 et le nombre de MACs utilisés par une couche dense standard est :

[Math 5]

$$MR = \frac{mn_i + mn_0}{n_i n_0} = \frac{m}{n_0} + \frac{m}{n_i}.$$

Le ratio *MR* est alors inférieur à 1 lorsque l'entier *m* est choisi de façon pertinente, par exemple lorsque m < $min(n_0, n_i)/2$.

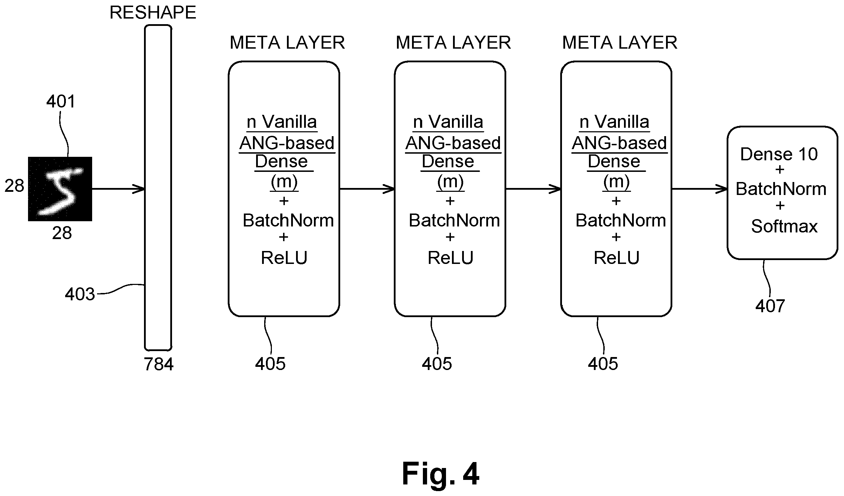

La figure 4 illustre un exemple de modèle d'un réseau de neurones profond comportant des couches denses comme illustrées en figure 2A, 2B ou 3.

En particulier, la figure 4 montre un exemple d'implémentation d'un réseau comportant des couches denses, comme décrites en relation avec la figure 2A ou 2B ou avec la figure 3, et étalonné à partir de la base de données MNIST contenant des représentations de chiffres manuscrits. Une image 401 de 28 pixels par 28 pixels, représentant par exemple le chiffre 5, est fournie en donnée d'entrée au réseau de neurones profond. L'image 401 est une matrice de pixel, chaque pixel étant par exemple représenté sur 8 bits. Ainsi, par exemple, l'image 401 peut être représentée sous forme de matrice de taille 28 par 28 dont chaque coefficient vaut, par exemple, une valeur entière entre 0 et 255 inclus. L'image 401 est ensuite transformée (RESHAPE) en un vecteur 403 de taille 784. A titre d'exemple, les 28 premiers coefficients du vecteur 403 représentent les 28 coefficients de la première colonne ou ligne de la représentation matricielle de l'image 401, les 28 deuxièmes coefficients du vecteur 403 représentent les 28 coefficients de la deuxième colonne ou ligne de la représentation matricielle de l'image 401, et ainsi de suite.

Le réseau 200 applique ensuite consécutivement trois méta-couches 405 (META LAYER) chacune composée, dans cet ordre, d'un nombre *n* de couches denses 201 fonctionnant, chacune, en combinaison d'un réseau auxiliaire 204 tel que décrit en relation avec la figure 2A et référencées comme étant des couches dites « Vanilla ANG-based Dense(*m*) ». Dans chaque méta-couches 405, les *n* couches « Vanilla ANG-based Dense (*m*) » sont suivies d'une couche de « Batch Normalization » (BatchNom), puis d'une couche ReLU. Une couche de sortie 407 consiste, par exemple, en l'application de 10 couches denses standards successives, puis d'une couche de Batch Normalization et d'une couche de classification Softmax générant une distribution de probabilité. A titre d'exemple, la sortie de la couche 407 est un vecteur de taille 10, dont le i-ème coefficient représente la probabilité que l'image d'entrée 401 représente le chiffre *i*, *i* étant un entier entre 0, et 9. La donnée de sortie du réseau est par exemple le chiffre ayant la plus grande probabilité.

La taille et la complexité du réseau de neurones profond ainsi décrit dépend du nombre *n* de couches « Vanilla ANG-based Dense(*m*)» et de la longueur *m* des vecteurs générés par le générateur 205 sur ces couches.

Selon un mode de réalisation, la fonction $\sigma$ non-linéaire utilisée à chaque couche « Vanilla ANG-based Dense(*m*) » est une fonction d'activation Softsign *h* définie par :

[Math 6]

$$h(x) = \frac{x}{|x| + 1}.$$

Le modèle ainsi décrit en relation avec la figure 4 a été testé et présente des performances élevées. En particulier, le modèle a été entraîné 5 différentes fois avec les paramètres *n* = 256 et *m* = 16 en utilisant un optimiseur d'Adam et une fonction de perte d'entropie croisée binaire (de l'anglais « Binary cross-entropy loss function ») et avec un taux d'apprentissage de $10^{-3}$ lors des 50 premières itérations de l'apprentissage (ou epochs) puis réduit par un facteur de 0.1 toutes les 25 itérations jusqu'à réalisation totale de 100 itérations. Un groupement de 100 données (en anglais batch) a été utilisé pour chaque itération. Le générateur de nombre 205 utilisé générait des nombres selon un loi normale centrée et réduite. Suite aux 5 entraînements, la précision moyenne pour le modèle décrit en relation avec la figure 4 est de 97.55% lorsque la fonction σ est linéaire et de 97.71% lorsque la fonction σ est remplacée par la fonction d'activation Softsign.

Le même entrainement a été effectué sur un réseau comme décrit en Figure 4, mais pour lequel les 256 couches « Vanilla ANG-based Dense (16) » ont été remplacées par 29 couches denses standards. Dans ce cas, la précision moyenne était seulement de 97.27%.

La précision moyennes des modèles, ainsi que le nombres de paramètres et de MACs utilisés, sont résumés dans le tableau suivant :

[Table 1]

| | Vanilla ANG-based Dense + Softsign (n=256, m=16) | Vanilla ANG-based Dense (n=256, m=16) | Dense Standard (n=29) | Dense Standard (n=256) |
|---|---|---|---|---|
| Précision | 97.71% | 97.55% | 97.27% | 98.58% |
| Nombres de paramètres | 24852 | 24852 | 24902 | 335892 |
| Nombre de MACs | 5642752 | 36362 | 24805 | 335114 |

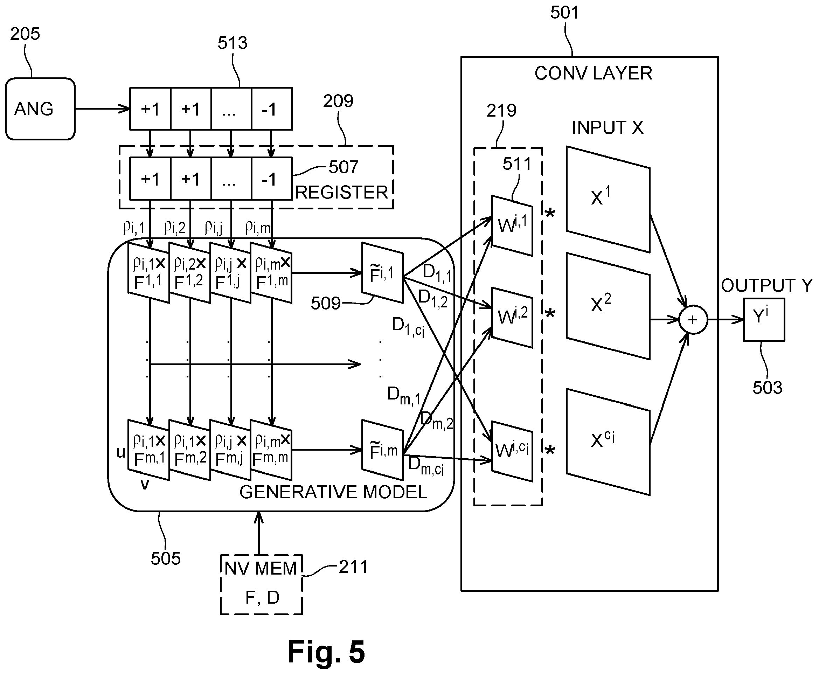

La figure 5 illustre un exemple d'implémentation d'une couche de convolution 501 (CONV LAYER) d'un réseau de neurones profond selon un mode de réalisation de la présente description.

La couche de convolution 501 prend une donnée d'entrée, qui est par exemple caractérisée comme étant un élément $X \in R^{h_i \times w_i \times c_i}$ (INPUT X), et génère une donnée de sortie $Y \in R^{h_0 \times w_0 \times c_0}$ (OUTPUT Y).

Les entiers $c_i$ et $c_0$ correspondent au nombre de canaux de la donnée d'entrée et de la donnée de sortie. Dans le cas où les données d'entrée et de sortie sont des images, les canaux sont par exemple des canaux de couleurs tels que rouge, vert et bleu. Les entiers $h_i$, $h_0$, $w_i$ et $w_0$ représentent par exemple respectivement les largeurs et hauteurs en pixel des images d'entrée et de sortie.

L'implémentation d'une couche de convolution standard prévoit l'utilisation d'un modèle de poids $W \in R^{u \times v \times c_i \times c_0}$ afin de générer la donnée de sortie *Y* à partir de la donnée d'entrée *X*. L'élément *W* se décompose alors en $c_0$ noyaux de convolution $W^i$, i $\in \{1, \cdots, c_0\}$ et chaque noyau $W^i$ comprend $c_i$ filtres de convolution $W^{i,j}$, $j \in \{1, \cdots, c_i\}$, de dimension $u \times v$, où *u* et *v* sont des entiers. Le i-ème canal $Y^i$ 503 est alors obtenu comme étant le produit de convolution entre la donnée d'entrée *X* et le noyau de convolution $W^i$. Autrement dit,

[Math 7]

$$Y^i = \sum_{j=1}^{c_i} X_j * W^{i,j}.$$

Le nombre de paramètres stockés dans une mémoire volatile, ou non volatile, pour l'implémentation d'une telle couche de convolution est alors la taille de l'élément *W*, soit $uvc_ic_0$ et le nombre de MACS utilisés est de $h_0w_0c_0uvc_i$.

Lorsque le nombre de canaux d'entrée $c_i$ et de sortie $c_0$ est grand, les ressources mémoires et les ressources de calculs requis sont importantes.

Dans les modes de réalisation décrits en relation avec la figure 5, au lieu de stocker l'élément $W$ dans une mémoire, on prévoit l'implémentation d'un réseau de neurones génératif auxiliaire 505 (GENERATIVE MODEL) pour générer les noyaux de convolution $W$ les uns après les autres.

Comme décrit en relation avec les figures 2 et 3, le dispositif sur lequel est implémentée la couche de convolution 501 comprend un générateur de nombres 205 (ANG) configuré pour générer des vecteurs $\rho$ de taille $m$, où l'entier $m$ est inférieur à la valeur $c_0$. Selon un mode de réalisation, le générateur de nombres 205 est un automate cellulaire configuré pour générer uniquement des vecteurs dont les coefficients sont à des valeurs dans $\{-1,1\}$. Le générateur de nombres 205 est en outre relié à un réseau de neurones génératif 505 (GENERATIVE MODEL). A titre d'exemple, le générateur 205 génère un vecteur $\rho_i$ 507 et le stocke par exemple dans le registre 209. Le vecteur $\rho_i$ 507 est ensuite fourni au réseau de neurones auxiliaire 505. Le réseau auxiliaire 505 est alors configuré pour générer un ensemble de $m$ filtres résultants $\tilde{F}^i$, composé d'un nombre $m$ de filtres de taille $u$ par $v$, sur la base du vecteur $\rho_i$ et d'un ensemble $F$ de $m \times m$ filtres $F^{k,h}$ à deux dimensions, où $k \in \{0,\cdots,m\}$ et $h \in \{1,\cdots,m\}$. L'ensemble $F$ est par exemple stocké dans la mémoire non-volatile 211.

Afin de générer l'ensemble $\tilde{F}^i$, chaque filtre $F^{k,h}$ de l'ensemble F, $k = 1,...,m$ et $h = 1,...,m$, est multiplié par le $h$-ème coefficient $\rho_{i,h}$ du vecteur $\rho_i$. Un premier filtre résultant $\tilde{F}^{i,1}$ 509 est alors défini par :

[Math 8]

$$\tilde{F}^{i,1} = \sigma_1\left(\sum_{h=1}^{m} F^{1,h}\rho_{i,h}\right),$$

où $\sigma_1$ est une fonction d'activation, telle qu'une fonction non-linéaire appliquée de manière indépendante sur chaque élément (en anglais « element-wise ») ou une opération de normalisation, telle qu'une opération par couche (en anglais « layer-wise ») ou par groupe (en anglais « group-wise ») ou tout type d'autre opération non-linaire. De manière générale, un $k$-ieme filtre résultant, k = 1,...$m$, $\tilde{F}^{i,k}$ est défini par :

[Math 9]

$$\tilde{F}^{i,k} = \sigma_1\left(\sum_{h=1}^{m} F^{k,h}\rho_{i,h}\right).$$

Les m filtres $\tilde{F}^{i,k}$, $k = 1,...,m$ sont alors par exemple combinés par le réseau 505 comme s'ils étaient des données d'entrée d'une couche dense standard. Une matrice de poids $D = \left(D_{k,h}\right)_{\substack{1 \le k \le m \\ 1 \le h \le c_i}}$ de taille $m$ par $c_i$ est par exemple stockée dans la mémoire non-volatile 211 et est fournie au réseau auxiliaire 505 afin d'obtenir les $c_i$ filtres $W^i$ pour la couche de convolution 501. Un premier filtre $W^{i,1}$ 511 est par exemple défini par :

[Math 10]

$$W^{i,1} = \sigma_2\left(\sum_{k=1}^{m} \tilde{F}^{i,k}D_{k,1}\right),$$

où $\sigma_2$ est une fonction d'activation, telle qu'une fonction non linéaire ou une opération de normalisation, telle qu'une opération par couche ou par groupe ou tout type d'autre opération non-linaire. De manière générale, un $h$-ème filtre $W^{i,h}$, $h = 1,... c_i$, est par exemple défini par :

[Math 11]

$$W^{i,h} = \sigma_2\left(\sum_{k=1}^{m} \tilde{F}^{i,k} D_{k,h}\right).$$

Les $c_i$ filtres $W^i$ sont alors par exemple stockés dans le registre 219 et fournis à la couche de convolution 501. La couche 501 génère par convolution une image de sortie $Y^i$, de taille $h_0$ par $w_0$ pixels, à partir des $c_i$ images d'entrée $X^1$, $X^2$,...,$X^{c_i}$, de taille $h_i$ par $w_i$ pixels. Autrement dit, $Y^i$ correspond au canal $i$ de l'image $Y$ de sortie et est défini par :

[Math 12]

$$Y^i = \sum_{h=1}^{c_i} X^k * W^{i,h}.$$

Le générateur 205 génère alors un nouveau vecteur $\rho_{i+1}$ 513, qu'il stocke par exemple dans le registre 209 écrasant au moins partiellement le vecteur $\rho_i$ 507. Le vecteur 513 est alors fourni au réseau génératif 505 afin de générer $c_i$ nouveaux filtres $W^{i+1}$ qui sont par exemple stockés dans la mémoire 219 écrasant au moins partiellement les filtres $W^i$. Les nouveaux filtres $W^{i+1}$ sont ensuite transmis à la couche de convolution 501 afin de générer le canal de sortie $Y^{i+1}$. Le générateur génère ainsi, les uns après les autres, $c_0$ vecteurs de taille $m$, chacun des vecteurs étant utilisé pour obtenir $c_i$ filtres pour la couche de convolution 501. Un nombre $c_0$ de canaux pour l'image $Y$ de sortie sont ainsi obtenus

Selon ce mode de réalisation, tous les filtres $W$ de la couche 501 sont générés à partir du réseau auxiliaire 505 à $m^2 uv + mc_i$ paramètres, $mc_i$ étant le nombre de coefficients de la matrice $D$ et $m^2 uv$ étant le nombre de paramètres caractérisant l'ensemble de filtres $F$. Le nombre de MACs requis est alors de $(uvm^2 + uvc_i m + h_0 w_0 uvc_i)c_0$, qui est supérieur au nombre de MACs utilisés pour l'implémentation d'une couche de convolution standard. En effet, le ratio $MR$ du nombre de MACs pour les modes de réalisation décrits en relation avec la figure 5 et le nombre de MACs pour une implémentation standard est $MR = 1 + \dfrac{m^2}{h_0 w_0 c_i} + \dfrac{m}{h_0 w_0}$ qui est supérieur à 1. Néanmoins, le fait d'utiliser le réseau auxiliaire 505 pour générer les noyaux W réduit de façon importante la taille de la mémoire qui serait utilisée dans une implémentation standard. En effet le ratio CR entre le nombre de paramètres mémorisés pour l'implémentation d'une couche de convolution selon la présente description et l'implémentation d'une couche de convolution standard peut être exprimé comme $CR = \dfrac{m^2 uv + mc_i}{uvc_i c_0} = \dfrac{m^2}{c_i c_0} + \dfrac{m}{uvc_0}$. La valeur de m est par exemple inférieure à $c_i$ ainsi qu'à $c_0$, et ce ratio est donc plus petit que 1.

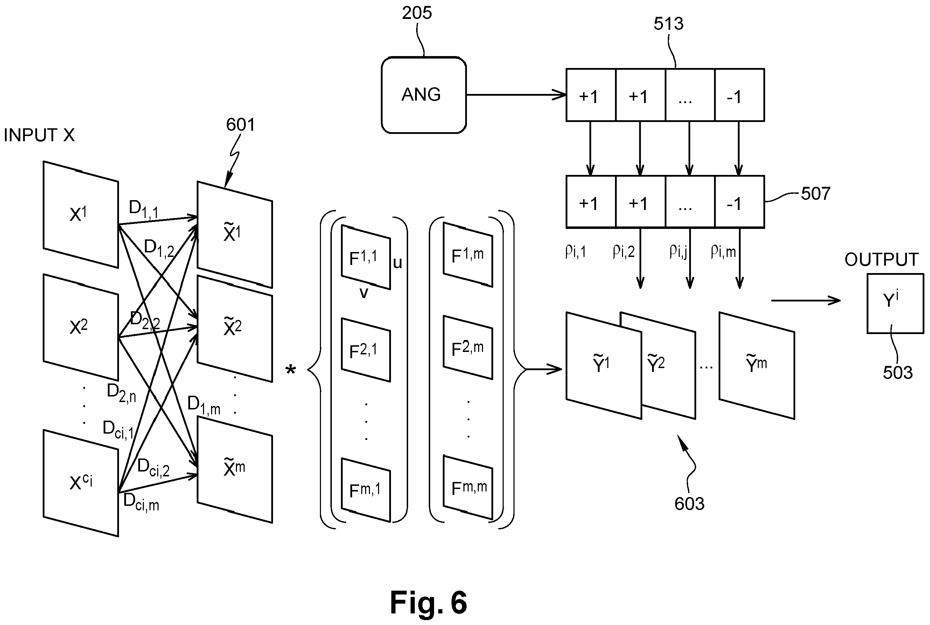

La figure 6 illustre un autre exemple d'implémentation d'une couche de convolution selon un mode de réalisation de la présente description. En particulier, la figure 6 illustre un exemple d'implémentation lorsque les fonction $\sigma_1$ et $\sigma_2$ sont linéaires, par exemple $\sigma_1$ et $\sigma_2$ sont la fonction identité. Dans ce cas, le nombre de MACs utilisés peut être réduit.

Selon un mode de réalisation, le nombre $c_i$ de canaux de la donnée d'entrée $X$ est réduit en un nombre m de canaux 601 $\tilde{X}^1, \tilde{X}^2,...,\tilde{X}^m$. En particulier chaque nouveau canal $\tilde{X}^k, k = 1, ...m$, est défini par :

[Math 13]

$$\tilde{X}^k = \sum_{j=1}^{c_i} D_{k,j} X^j.$$

Les m nouveaux canaux sont convolués avec les filtres de l'ensemble $F$ afin d'obtenir $m$ nouveaux canaux $\tilde{Y}^h$ 603, $h = 1,...,m$. Chaque nouveau canal $\tilde{Y}^h$ est défini par :

[Math 14]

$$\tilde{Y}^h = \sum_{k=1}^{m} F^{k,h} * \tilde{X}^k.$$

Le i-ème canal de sortie 503 est alors généré à partir des canaux $\tilde{Y}^h$, $h = 1, ..., m$, et à partir d'un vecteur $\rho_i$, par exemple le vecteur 507, généré par le générateur de nombres 205. Le i-ème canal de sortie $Y^i$ 503 est alors défini par :

[Math 15]

$$Y^i = \sum_{h=1}^{m} \rho_{i,h} \tilde{Y}^h.$$

Le générateur 205 génère ensuite un vecteur $\rho_{i+1}$, par exemple le vecteur 513, à partir duquel le i+1-ème canal de sortie $Y^{i+1}$ est obtenu comme combinaison linéaire des coefficients du vecteur $\rho_{i+1}$ et des canaux $\tilde{Y}^h$ 603, h= 1,...,m, déjà calculés.

Le nombre de MACs utilisés pour l'implémentation décrite en relation avec la figure 6 est de $h_0 w_0 m c_i + h_0 w_0 m^2 uv + h_0 w_0 c_0 m$. Ainsi le ratio MR entre le nombre de MACs utilisés pour l'implémentation décrite en relation avec la figure 6 et le nombre de MACs utilisés pour l'implémentation d'une couche de convolution standard est $MR = \frac{m}{uvc_0} + \frac{m^2}{c_i c_0} + \frac{m}{uvc_i}$. Ce ratio est inférieur à 1 lorsque l'entier $m$ est choisi de manière pertinente, par exemple en prenant $m \leq \min(c_0, c_i)$.

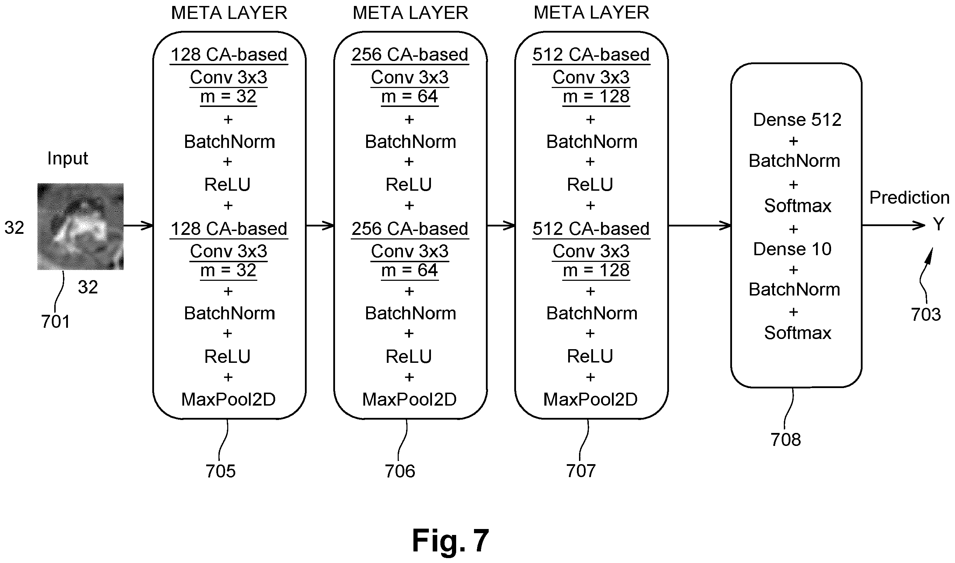

La figure 7 est un exemple de modèle d'un réseau de neurones profond comportant des couches de convolution comme illustrées en figure 5 ou en figure 6.

En particulier, la figure 7 montre un exemple d'un réseau de neurones profonds comportant des couches de convolution comme décrites en relation avec les figures 5 et 6 et étalonnées à partir de la base de données CIFAR-10 contenant des images appartenant à dix classes différentes. Chaque classe (avions, voitures, oiseaux, chats, cerfs, chiens, grenouilles, chevaux, bateaux et camions) est représentée par 60000 images de tailles 32 par 32 pixels et décrites par 3 canaux de couleurs (rouge, vert et bleu). Une image 701 de la base de données, dans cet exemple représentant une grenouille, est fournie en donnée d'entrée à un réseau de neurones profond composé de plusieurs couches de convolution dont l'implémentation est décrite en relation avec les figures 5 ou 6. Le réseau de neurones a pour but de fournir une prédiction 703 de la classe à laquelle appartient l'image. Par exemple, la donnée de sortie attendue est la chaîne de caractère « grenouille ».

Les couches de convolutions du réseau de neurones fonctionnent en combinaison d'un réseau auxiliaire 505 tel que décrit en relation avec les figures 5 ou 6 et sont référencées comme étant des couches dites « CA-based Conv(m) ». Dans l'implémentation illustrée en figure 7, les filtres de l'ensemble F et les coefficients de la matrice D sont binarisés et le générateur 205 est un automate cellulaire configuré selon la règle 30 d'après classification dans la table de Wolfram comme connue dans l'art, et ayant une initialisation aléatoire.

Le réseau de neurones décrit applique trois méta-couches 705, 706 et 707 (META LAYER) chacune composée, dans cet ordre, de un nombre n de couches «CA-based Conv($m$) 3x3 » suivie, facultativement, d'une couche de « Batch Normalization », correspondant à la normalisation non-linéaire des couches de convolution 501, apportée par la fonction $\sigma_2$, d'une couche ReLU, d'une nouvelle couche « CA-based Conv(m) 3x3 » suivie d'une nouvelle couche « BatchNorm » et d'une nouvelle couche ReLU. Les méta-couches 705, 706 et 707 se terminent chacune par une couche « MaxPool2D ».

Le nombre n de couches de convolution dans la méta-couche 705 est n=128 et le paramètre m associé à chaque couche est m=32. Le nombre n de couches de convolution dans la méta-couche 706 est n=256 et le paramètre m associé à chaque couche est m=64. Enfin, le nombre n de couches de convolution dans la méta-couche 707 est n=512 et le paramètre m associé à chaque couche est m=128.

La couche de sortie 708 consiste en l'application d'une couche dense de taille 512, d'une couche « BatchNorm », d'une couche de classification Softmax, et d'une nouvelle couche dense de taille 10. A titre d'exemple, la sortie de la couche 708 est un vecteur de taille 10, le 10 correspondant aux 10 classes de la base de données. La couche 708 comprend ensuite une nouvelle couche « BatchNorm » puis une nouvelle couche Softmax. La donnée de sortie du réseau est par exemple le nom de la classe ayant la plus grande probabilité suite à l'application de la dernière couche de classification.

Le modèle ainsi décrit en relation avec la figure 7 a été testé et entraîné en utilisant un optimiseur d'Adam sur 150 itérations (ou epochs). Un taux d'apprentissage de $10^{-3}$ est fixé pour les 50 premières itérations de l'apprentissage puis est réduit par un facteur de 0,1 toutes les 25 itérations jusqu'à réalisation totale de 150 itérations. Un groupement de 50 données (en anglais « batch ») est utilisé pour chaque itération. Suite à l'entrainement, la précision moyenne pour le modèle décrit en relation avec la figure 5 était de 91,15%. Lorsque les couches « CA-based Conv(m) » sont suivies d'une couche de normalisation additionnelle correspondant à l'application de la fonction $\sigma_2$, comme fonction de normalisation de chacun des noyaux $W^i$, la précision moyenne montait à 91,26%. Dans le cas où les couches de convolution sont des couches de convolution standards, c'est-à-dire des couches de convolutions qui ne sont pas combinées à un générateur de nombres, la précision moyenne était de 93,12%. Néanmoins la mémoire utilisée pour une telle implémentation était quasiment 400 fois supérieure que pour les deux implémentations précédentes.

La précision moyennes des modèles ainsi que le nombres de paramètres et de MACs utilisés sont résumés dans le tableau suivant :

[Table 1]

| | CA-based Conv + BatchNorm | CA-Based Conv (sans BatchNorm) | Conv Standard |
|---|---|---|---|
| Précision | 91,26% | 91,15% | 93,12% |
| Mémoire | 0,37 Megabytes | 0,37 MegaBytes | 146 MegaBytes |
| Nombre de MACs | 1299 | 99 | 608 |

Tous les exemples de réalisation décrits précédemment décrivent le fonctionnement d'un réseau de neurones comprenant au moins une couche mettant en oeuvre un procédé de génération des paramètres de cette couche neuronale correspondant aux valeurs de paramètres prédéfinies, ou plus exactement apprises au préalable grâce à un procédé d'apprentissage. De façon connu en soi, un procédé d'apprentissage d'un réseau neurone consiste à définir les valeurs des paramètres du réseau de neurones, c'est-à-dire à définir les valeurs des paramètres correspondant essentiellement aux poids des synapses. L'apprentissage se fait classiquement au moyen d'une base de données d'apprentissage comprenant des exemples de données d'entrée et de sorties attendues correspondantes.

Dans le cas où le réseau de neurones intègre une couche de neurones (Layer l) 201 telle que décrite en relation avec la figure 2A, l'apprentissage de cette couche de neurone 201 peut se faire de plusieurs façons.

Une façon de réaliser l'apprentissage consiste dans un premier temps à apprendre les valeurs des paramètres de la matrice $W^T$ sans considérer la génération de ces paramètres par le modèle génératif, en réalisant un procédé d'apprentissage classique du réseau de neurones global par un procédé de rétro propagation de l'erreur (depuis la sortie du réseau vers l'entrée). On réalise ensuite, dans un deuxième temps, l'apprentissage des paramètres du modèle génératif 204 (en définissant $\Omega$) avec comme base de données d'apprentissage une base constituée d'une part d'une séquence prédéfinie de vecteurs (p) destinés à être générés par le générateur ANG 205 (sur la base d'une « graine » prédéfinie) lors d'une séquence d'inférence et d'autre part des vecteurs $W_i$ attendus respectivement pour chacun des vecteurs $\rho_i$. Un avantage de cette première façon de faire l'apprentissage est potentiellement sa plus grande simplicité de calcul des paramètres. Néanmoins, il est possible que ce procédé en deux étapes conduise à introduire des imperfections dans la génération des valeurs de la matrice $W^T$ lors d'inférences ultérieures (en phase d'utilisation du réseau de neurones).

Une autre façon de réaliser l'apprentissage consiste à apprendre les paramètres du modèle génératif 204 en même temps que l'apprentissage des paramètres de la matrice $W^T$ en réalisant une rétro propagation de l'erreur jusqu'à la matrice $\Omega$. Il est en effet possible d'utiliser un algorithme d'optimisation (tel qu'une rétropropagation de l'erreur) jusqu'aux valeurs de $\Omega$, connaissant d'une part la sortie attendue du réseau principal, son entrée ainsi que la séquence prédéfinie de vecteurs (p) destinés à être générés par le générateur ANG 205 (sur la base d'une « graine » prédéfinie) lors d'une séquence d'inférence.

On notera que dans tous les exemples décrits précédemment, les paramètres de la couche de neurones que l'on souhaite définir (les paramètres de la matrice $\Omega$ en pratique) correspondent à des valeurs de paramètres d'un réseau de neurones dont la topologie est préalablement définie. La topologie d'un réseau de neurones permet notamment de définir, pour chaque couche de neurones, le type et le nombre de synapses reliées à chaque neurone. De façon générale, pour définir une topologie d'un réseau de neurones on parle de méta-paramètres de ce réseau de neurones. Ainsi, dans les exemples précédemment décrits, les méta-paramètres se retrouvent dans la définition des fonctions *f* et *g*. Ces fonctions incluent respectivement une matrice de passage W et $\Omega$. Les paramètres évoqués précédemment (dans les différents exemples) correspondent donc ainsi à des valeurs données (apprises) des matrices de passage $\Omega$ et W.

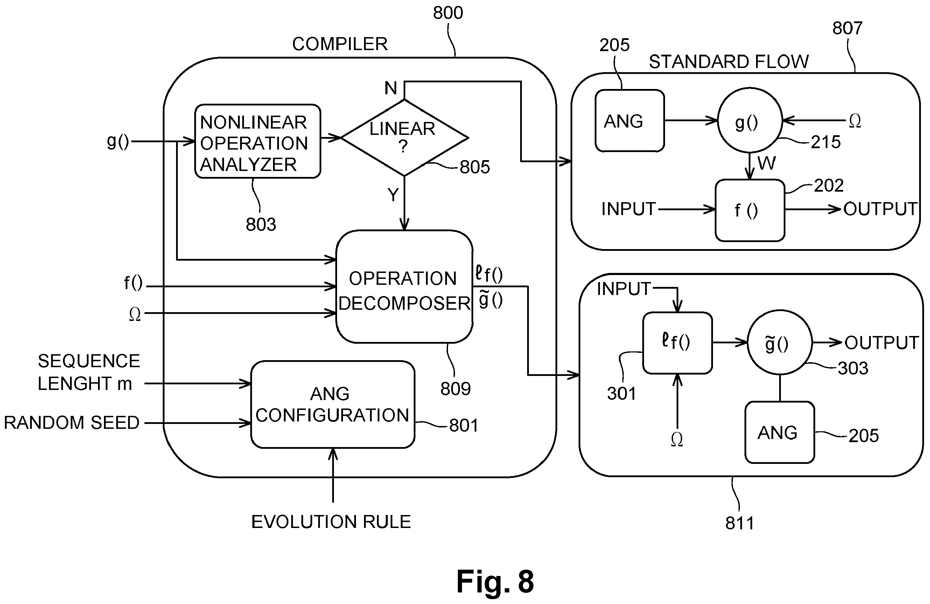

La figure 8 est un schéma par bloc illustrant une implémentation d'un compilateur 800 (COMPILER) utilisé pour opération de conception de circuit permettant l'implémentation matérielle d'un réseau de neurones tel que décrit en relation avec les figures 2, 3, 4, 5 ou 6.

Le compilateur 800 comprend une étape de détermination de la configuration 801 (ANG CONFIGURATION) souhaitée du générateur de nombres 205. La configuration de générateur de nombres est par exemple celle d'un automate cellulaire ou celle d'un générateur de nombres pseudo-aléatoires. Par configuration du générateur, on entend la définition de sa topologie, par exemple le nombre de bascules et/ou portes logiques, de connexions de rebouclage, d'un générateur. Le générateur de nombres 205 est capable de générer une séquence de nombres à partir d'une graine (RANDOM SEED), d'une indication de la dimension de chaque vecteur généré (SEQUENCE LENGTH m) et d'une règle (EVOLUTION RULE), ces trois éléments étant spécifiés en entrée du compilateur. Lorsque le générateur de nombres 205 est un générateur congruentiel linéaire, la règle est par exemple l'algorithme utilisé par le générateur congruentiel 205, tel que, par exemple, l'algorithme « Standard minimal ». Dans un autre exemple, le générateur de nombre 205 est un registre à décalage à rétroaction linéaire implémenté de manière matérielle. La configuration souhaitée du générateur de nombres peut être réalisée par une recherche de topologie optimale en minimisant une fonction de coût prédéfinie pouvant par exemple tenir compte des facteurs tels que l'encombrement, la vitesse de production d'un nombre aléatoire, etc. La topologie optimale mettant en oeuvre les contraintes spécifiées (m ; ramdom seed ; évolution rule) peut être recherchée dans une base de données de topologie de circuits en comparant les performances des différentes topologies une fois adaptées (de l'anglais « customise ») aux contraintes spécifiées.

Le compilateur 800 peut également être utilisé pour analyser des spécifications données pour mettre en oeuvre une couche d'un réseau de neurones telle que définie, ou encore modélisée, par la représentation générique illustrée en figure 2A. Les données en entrées du compilateur sont alors une topologie de réseau de neurones définie notamment par les fonctions $g$ et $f$ ainsi qu'une matrice de paramètres $\Omega$. Le compilateur réalise alors un ensemble d'opérations d'analyse sur la base de ces spécifications d'entrées, pouvant éventuellement considérer également les spécifications données pour le générateur de nombre aléatoires. Afin de faciliter la mise en oeuvre des opérations d'analyse réalisées par le compilateur, la fourniture des fonctions $g$ et $f$ peut être réalisée sous la forme d'une combinaison mathématique de fonctions de librairies prédéfinies, en lien par exemple avec les différentes topologies envisageables pour l'implémentation du réseau de neurones.

Le compilateur est donc prévu pour effectuer une opération 803 (NONLINEAR OPERATION ANALYZER) d'analyse de non-linéarité qui détermine si oui ou non la fonction g, utilisée par exemple par le réseau auxiliaire 204, est une fonction non-linéaire. Puis, selon le résultat de l'opération 803, une opération d'aiguillage 805 (LINEAR ?), va décider de la suite du procédé de compilation par le compilateur 800, selon que la fonction $g$ est linéaire ou non.

Dans le cas où la fonction $g$ est non-linéaire (branche N), le compilateur 800 génère, dans une opération 807 (STANDARD FLOW), une définition « haut niveau » d'une couche de neurones reprenant une définition « haut niveau » d'un circuit tel que décrit en relation avec la figure 2A. Par définition haut niveau d'un circuit, on pourra par exemple comprendre une représentation matlab, ou une définition selon un format de programmation, par exemple le langage C, ou encore une représentation au niveau RTL (pour « Register Transfer Level ») du circuit. Le compilateur fournit ainsi une représentation haut-niveau d'un circuit tel que représenté schématiquement par ses briques principales illustrées en référence 807.

Dans le cas où la fonction $g$ est linéaire (branche Y), un décomposeur d'opération 809 (OPERATION DECOMPOSER) reçoit la fonction $g$ ainsi que la fonction de couche $f$ et la matrice $\Omega$ et génère deux fonctions latentes $lf$ et $\tilde{g}$ permettant la mise en oeuvre, dans une opération 811, de l'implémentation d'un réseau de neurones tel que décrit en relation avec la figure 3. En fonction du type des réseaux auxiliaires, la fonction $\tilde{g}$ se décompose en de multiples opérations. A titre d'exemple, lorsque le réseau est du type décrit en relation avec la figure 6, la fonction $\tilde{g}$ se décompose en convolutions avec les filtres F suivie d'une combinaison avec les vecteurs aléatoires $\rho_i$.

Bien que la figure 8 illustre la fourniture des fonctions $f$ et $g$, décrites en relation avec les figures 2 et 3, l'opération 803 permet de déterminer la linéarité ou non des fonctions $\sigma_1$ et $\sigma_2$ décrites en relation ave les figures 6 et 7 et l'opération 809 permet, le cas échéant, de décomposer les noyaux de convolution comme décrit en relation avec la figure 7.

L'opération 809 délivre ainsi une définition « haut niveau » d'une couche de neurones reprenant une définition « haut niveau » d'un circuit « décomposable » tel que représenté schématiquement, par ses briques principales illustrées en référence 811.

Outre les étapes d'analyse fonctionnelles du compilateur décrites précédemment, l'outil de conception de circuit par ordinateur peut comprendre la réalisation d'autres étapes de conception visant, à partir des représentations de circuit « haut-niveau », à réaliser la génération d'autres fichiers de conception plus « bas-niveaux ». Ainsi, l'outil de conception par ordinateur permet de délivrer un ou plusieurs fichiers de conception représentant des vues EDA (de l'anglais "Electronic Design Automation" - automatisation de conception électronique), et/ou une vue HDL (de l'anglais "Hardware Description Language" - langage de description matérielle). Dans certains cas, ces fichiers, souvent dénommés « IP » (propriété intellectuelle), peuvent être en langage RTL configurable (de l'anglais "Register Transfer Level" - langage à transfert de registres). Cette conception de circuit par ordinateur permet ainsi de définir par exemple in fine le circuit dans un format de fichier (classiquement fichier gds2) qui permette sa fabrication dans un site de fabrication. Dans certains cas, le fichier final de sortie de l'opération de conception de circuit est transmis vers un site de fabrication pour être fabriquée. On notera que de façon connue en soi, les fichiers fournis par le compilateur peuvent être transmis dans un format plus ou moins haut niveau à un tiers en vue de son utilisation par ce tiers dans son flot de conception de circuit.

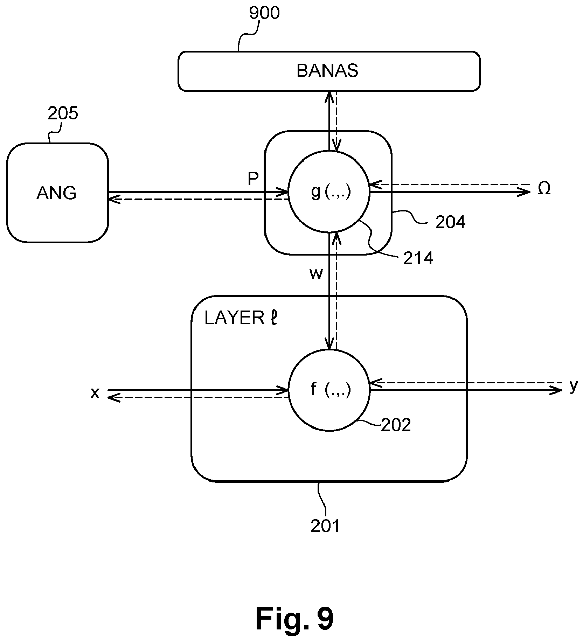

La figure 9 est un schéma par bloc illustrant une implémentation d'un outil de recherche automatique d'architecture neuronale 900 selon un mode de réalisation de la présente description.

L'outil de recherche automatique 900 est implémenté de façon logicielle par un ordinateur. L'outil de recherche 900 vise par exemple à sélectionner, parmi plusieurs topologies candidates, des topologies pour l'implémentation des réseaux principal 201 et génératif 204 ou 505 ainsi qu'une topologie pour l'implémentation du générateur de nombres 205. La sélection effectuée par l'outil de recherche 900 répond à certaines contraintes telles que la capacité des mémoires, le type d'opérations, le nombre maximal de MACs, la précision recherchée sur les résultats d'inférence, ou tout autre indicateur de performance matérielle. L'outil de recherche automatique met en oeuvre une technique de recherche connue sous le nom de NAS de l'anglais (Neural Architecture Search). Cette recherche prend en compte un ensemble de critères d'optimisation et s'appelle « BANAS » de l'anglais « Budget-Aware Neural Architecture Search ». En outre, l'outil de recherche automatique neuronal (NAS) peut être adapté pour tenir compte de la spécificité d'une couche de neurones selon un mode de réalisation de l'invention utilisant une génération à la volée des paramètres du réseau à partir d'une séquence de nombres fournies par un générateur de nombre aléatoires. Les flèches représentées en pointillés sur la figure 9 illustrent le fait que cet outil de recherche BANAS cherche à optimiser la topologie du réseau de neurones en considérant d'une part les opérations d'apprentissage et leurs performances selon la topologie du réseau et d'autre part des métriques de performance que l'on cherche à optimiser telles que la capacité mémoire, la capacité de calcul, la vitesse d'exécution.

Selon un mode de réalisation, l'outil de recherche 900 est couplé avec le compilateur 800 décrit en relation avec la figure 8. L'outil de recherche 900 soumet une topologie candidate pour le générateur de nombre 205 (en précisant les données d'entrée : SEQUENCE LENGTH m ; RANDOM SEED ; EVOLUTION RULE) au compilateur 800 ainsi qu'une topologie du réseau auxiliaire 204 ou 505 (en précisant les données d'entrée $g$ ; $f$ ; et $\Omega$).

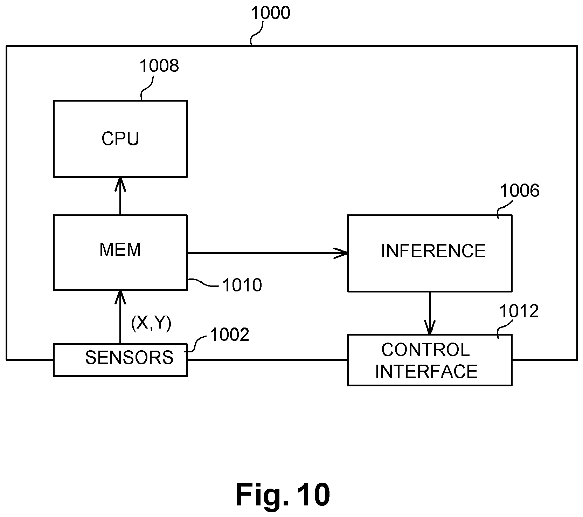

La figure 10 illustre un système matériel 1000 selon un exemple de mode de réalisation de la présente description. Le système 1000 comprend par exemple un ou plusieurs capteurs (SENSORS) 1002, qui comprennent par exemple un ou plusieurs capteurs de type imageurs, des capteurs de profondeur, des capteurs thermiques, des microphones, des outils de reconnaissance vocale ou tout autre type de capteurs. Par exemple, dans le cas où les capteurs 1002 comprennent un imageur, l'imageur est par exemple un imageur de lumière visible, un imageur infrarouge, un imageur sonore, un imageur de profondeur, par exemple de type LIDAR (Détecteur de lumière et de profondeur, en anglais « Light Détection and Ranging »), ou tout autre type d'imageurs.

Lesdits un ou plusieurs capteurs 1002 fournissent de nouveaux échantillons de données, par exemple des images brutes ou prétraitées, à un module d'inférence (INFERENCE) 1006 par l'intermédiaire d'une mémoire tampon 1010 (MEM). Le module d'inférence 1006 comprend par exemple le réseau de neurones profond décrit en relation avec les figures 2 à 7. Dans certains modes de réalisation, certaines parties de ce réseau de neurones profond sont implémentées par une unité de traitement (CPU) 1008 sous la commande d'instructions stockées dans une mémoire, par exemple dans la mémoire 1010.

En fonctionnement, lorsqu'un nouvel échantillon de données est reçu, par l'intermédiaire d'un capteur 1002, il est fourni au module d'inférence 1006. L'échantillon est alors traité, par exemple afin d'effectuer une classification. A titre d'exemple, lorsque que l'échantillon se compose d'images, l'inférence effectuée permet d'identifier une scène en prédisant par exemple l'objet représenté sur l'image tel qu'une chaise, un avion, une grenouille, etc. Dans un autre exemple, l'échantillon se compose de signaux vocaux et l'inférence permet d'effectuer, entre autres, de la reconnaissance vocale. Encore dans un autre exemple, l'échantillon se compose de vidéos, et l'inférence permet par exemple d'identifier une activité ou des gestes. Bien d'autres applications sont possibles et sont à la portée de la personne du métier.

Une sortie du module d'inférence 1006 correspondant à une classe prédite est par exemple fournie à une ou plusieurs interfaces de commande (CONTROL INTERFACE) 1012. Par exemple, les interfaces de commande 1012 sont configurées pour piloter un ou plusieurs écrans afin d'afficher des informations indiquant la prédiction, ou une action à faire en fonction de la prédiction. Selon d'autres exemples, les interfaces de commande 1012 sont configurées pour piloter d'autres types de circuits, tels qu'un circuit de réveil ou de sommeil pour activer ou désactiver tout ou partie d'une puce électronique, un circuit d'activation d'écran, un circuit de freinage automatique d'un véhicule, etc.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, de diverses configurations des générateurs de nombres 205 peuvent être utilisées. Le générateur 205 peut être un générateur de nombres pseudo-aléatoires dont l'implémentation matérielle est un registre à décalage à rétroaction linéaire (LFSR, de l'anglais « Linear Feedback Shift Register »), un automate cellulaire, ou n'importe quelle implémentation matérielle capable de générer des suites de nombres. Divers réglages du générateur 205 sont aussi possibles. Les nombres générés peuvent être des nombres binaires, des entiers, ou encore des nombres flottants. L'initialisation du générateur peut être fixée préalablement ou horodatée, la graine étant alors par exemple la valeur d'une horloge du circuit.

Lorsque le générateur 205 et/ou 505 est un automate cellulaire, une règle de génération de nombre peut être apprise lors de l'apprentissage du réseau de neurones profond pour ainsi par exemple définir la meilleure initialisation du générateur.

Enfin, la mise en oeuvre pratique des modes de réalisation et variantes décrits est à la portée de la personne du métier à partir des indications fonctionnelles données ci-dessus.

**Revendications**

1. Circuit comprenant :

- un générateur de nombres (205) configuré pour générer une séquence de vecteurs ($\rho_i$, $\rho_{i+1}$, 207, 219, 507, 513) de taille $m$, la séquence de vecteurs étant la même à chaque démarrage du générateur de nombre ;
- une mémoire (211) configurée pour stocker un ensemble de premiers paramètres ($\Omega$,**F**, **D**) d'un réseau de neurones auxiliaire (204,505) ;
- un dispositif de traitement configuré pour générer un ensemble de deuxièmes paramètres (**W**) d'une couche (201, 501) d'un réseau de neurones principal en appliquant plusieurs fois une première opération (**g,** F, D), par le réseau de neurones auxiliaire, réalisant une opération de génération à partir de chaque vecteur généré ($\rho_i$) par le générateur de nombres, chaque génération délivrant un vecteur de deuxième paramètres (**$W_i$**),

l'ensemble des vecteurs de deuxièmes paramètres constituant ledit ensemble de deuxièmes paramètres ; et dans lequel le nombre de deuxièmes paramètres est supérieur au nombre de premiers paramètres.

2. Circuit selon la revendication 1, dans lequel la première opération est non-linéaire.

3. Circuit selon la revendication 1 ou 2, comprenant en outre une mémoire volatile (209) configurée pour stocker les vecteurs de la séquence de vecteurs.

4. Circuit selon la revendication 3, dans lequel le générateur de nombres (205) est configuré pour stocker le premier vecteur ($\rho_1$) dans la mémoire volatile (209) et pour générer un deuxième vecteur ($\rho_2$), dans lequel le deuxième vecteur est stocké dans la mémoire entraînant la suppression du premier vecteur.

5. Circuit selon l'une quelconque des revendications 1 à 4, dans lequel le dispositif de traitement est en outre configuré pour réaliser une opération d'inférence à travers ladite couche du réseau de neurone principal en appliquant au moins une deuxième fonction (f) à partir des deuxièmes paramètres (**$W_i$**) et d'un vecteur d'entrée **(x)** de ladite couche, l'opération d'inférence à travers la couche de neurones délivrant un vecteur de sortie **(y, Y),** et dans lequel la taille **$n_0$** du vecteur de sortie est supérieure à la taille **$m$** d'un vecteur généré par le générateur de nombres (205).

6. Circuit selon la revendication 5, dans lequel le vecteur de sortie (**y**, **Y**) est généré, par la couche (201, 501) du réseau de neurones principal, coordonnée par coordonnée, par application d'au moins la deuxième fonction (**f**) aux deuxièmes paramètres (**$W_i$**) et au vecteur d'entrée (**x**).

7. Circuit selon la revendication 6, dans lequel le vecteur d'entrée (x) est une image.

8. Circuit selon l'une quelconque des revendications 1 à 7, dans lequel la couche (201) du réseau de neurones principal est une couche dense ou une couche de convolution.

9. Circuit selon l'une quelconque des revendications 1 à 8, dans lequel le générateur de nombres (205) est une automate cellulaire.

10. Circuit selon l'une quelconque des revendications 1 à 8, dans lequel le générateur de nombres (205) est un générateur de nombres pseudo-aléatoires, le générateur de nombres (205) étant par exemple un registre à décalage à rétroaction linéaire.

11. Compilateur (800) mis en oeuvre par ordinateur par un outil de conception de circuit, le compilateur recevant une description topologique d'un circuit tel que revendiqué en revendication 5, la description topologique précisant la première (**g**) et deuxième (**f**) fonction ainsi que la configuration du générateur de nombres (ANG), le compilateur étant configuré pour déterminer si la première opération (***g***) est linéaire ou non-linéaire, et si la première opération est non-linéaire, le compilateur étant configuré pour générer un fichier de conception d'un circuit selon l'une quelconque des revendications 1 à 10.

12. Compilateur selon la revendication 11, configuré pour effectuer, dans le cas où la première opérations (***g***) est linéaire, la conception d'un circuit de sorte que le circuit mette en oeuvre une décomposition d'opérations en appliquant séquentiellement une troisième opération (*lf*) et une quatrième opération ($\tilde{g}$) équivalente à la combinaison de la première opération (***g***) et la deuxième opérations (***f***), la troisième opération prenant comme variables d'entrée le vecteur d'entrée (***x***) et les premiers paramètres ($\Omega$,**F**,**D**) et la quatrième opération prenant en entrée la séquence de vecteurs ($\rho_i$) générés par le générateur de nombres (205) et la sortie de la troisième opération (*lf*) et délivrant ledit vecteur de sortie (***y***,**Y**) .

13. Procédé de conception par ordinateur d'un circuit selon l'une quelconque des revendications 1 à 10, comprenant, préalablement à la mise en oeuvre d'un compilateur selon la revendication 11 ou 12, la mise en oeuvre d'un procédé de recherche de topologie optimale de réseaux de neurones principal et/ou génératif, et délivrant lesdites données de description topologique audit compilateur.

14. Procédé de traitement de données comprenant, pendant une phase d'inférence :

   - la génération d'une séquence de vecteurs ($\rho_\mathbf{i}$, $\rho_{i+1}$, 207, 219,507, 513) de taille ***m***, par un générateur de nombres (205), la séquence de vecteurs étant la même à chaque démarrage du générateur de nombre ;
   - le stockage d'un ensemble de premiers paramètres ($\Omega$,**F**,**D**) d'un réseau de neurones auxiliaire (204, 505) dans une mémoire (211) ;
   - la génération, par un dispositif de traitement, d'un ensemble de deuxièmes paramètres (***W***) d'une couche (201, 501) d'un réseau de neurones principal en appliquant plusieurs fois une première opération (*g*, F, D), par le réseau de neurones auxiliaire, réalisant une opération de génération à partir de chaque vecteur généré ($\rho_i$) par le générateur de nombres, chaque génération délivrant un vecteur de deuxième paramètres (***W***$_i$),

   l'ensemble des vecteurs de deuxièmes paramètres constituant ledit ensemble de deuxièmes paramètres ; et dans lequel le nombre de deuxièmes paramètres est supérieur au nombre de premiers paramètres.

15. Procédé selon la revendication 14, comprenant en outre, une phase d'apprentissage du réseau de neurones auxiliaire, préalable à la phase d'inférence, la phase d'apprentissage comprenant l'apprentissage d'une matrice de poids ($\Omega$), sur la base de la séquence de vecteurs générée par le générateur de nombres (205), la séquence de vecteurs étant identique à la séquence de vecteurs générée dans l'étape d'inférence.

LAYER KERNEL
w

LAYER ℓ          MAIN MODEL

LAYER ℓ-1

LAYER ℓ+1

INPUT
x

f (.,.)

103

OUTPUT
y

101

100

102

**Fig. 1**

**Fig. 2A**

EP 4 202 770 A1

**Fig. 2B**

**Fig. 2C**

**Fig. 3**

EP 4 202 770 A1

**Fig. 4**

EP 4 202 770 A1

CONV LAYER 501

INPUT X

$X^1$

$X^2$

$X^{c_i}$

OUTPUT Y

$Y^i$ 503

219

511

$W^{i,1}$ *

$W^{i,2}$ *

$W^{i,c_i}$ *

$D_{1,1}$  $D_{1,2}$  $D_{1,c_i}$  $D_{m,1}$  $D_{m,2}$  $D_{m,c_i}$

$\tilde{F}_{i,1}$  509  $\tilde{F}_{i,m}$

GENERATIVE MODEL

ANG 205

513

| +1 | +1 | ... | −1 |

REGISTER 507

209

| +1 | +1 | ... | −1 |

$\rho_{i,1}$  $\rho_{i,2}$  $\rho_{i,j}$  $\rho_{i,m}$

$\rho_{i,1} \times F_{1,1}$  $\rho_{i,2} \times F_{1,2}$  $\rho_{i,j} \times F_{1,j}$  $\rho_{i,m} \times F_{1,m}$

$\rho_{i,1} \times F_{m,1}$  $\rho_{i,1} \times F_{m,2}$  $\rho_{i,j} \times F_{m,j}$  $\rho_{i,m} \times F_{m,m}$

u  v  505

NV MEM 211

F, D

**Fig. 5**

Fig. 6

**Fig. 7**

**Fig. 8**

EP 4 202 770 A1

**Fig. 9**

**Fig. 10**

**RAPPORT DE RECHERCHE EUROPEENNE**

Europäisches Patentamt
European Patent Office
Office européen des brevets

Numéro de la demande

EP 22 21 4809

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | LIOR DEUTSCH ET AL: "A Generative Model for Sampling High-Performance and Diverse Weights for Neural Networks", ARXIV.ORG, CORNELL UNIVERSITY LIBRARY, 201 OLIN LIBRARY CORNELL UNIVERSITY ITHACA, NY 14853, 7 mai 2019 (2019-05-07), XP081270099, * Sections 3.3, 4.2, 5 et annexes F, G, H; figure 4 * | 1-15 | INV. G06N3/045 G06N3/047 ADD. G06N3/063 G06N3/084 |
| A | QIYU WAN ET AL: "Shift-BNN: Highly-Efficient Probabilistic Bayesian Neural Network Training via Memory-Friendly Pattern Retrieving", ARXIV.ORG, CORNELL UNIVERSITY LIBRARY, 201 OLIN LIBRARY CORNELL UNIVERSITY ITHACA, NY 14853, 7 octobre 2021 (2021-10-07), XP091074086, DOI: 10.1145/3466752.3480120 * Section 4.1 * | 1-15 | |
| A | CHRISTIAM F FRASSER ET AL: "Fully-parallel Convolutional Neural Network Hardware", ARXIV.ORG, CORNELL UNIVERSITY LIBRARY, 201 OLIN LIBRARY CORNELL UNIVERSITY ITHACA, NY 14853, 22 juin 2020 (2020-06-22), XP081708002, * Section II.F * | 1-15 | DOMAINES TECHNIQUES RECHERCHES (IPC) G06N |

-/--

Le présent rapport a été établi pour toutes les revendications

| Lieu de la recherche | Date d'achèvement de la recherche | Examinateur |
|---|---|---|
| La Haye | 31 mars 2023 | Szymanski, Francois |

EPO FORM 1503 03.82 (P04C02)

page 1 de 2

Europäisches
Patentamt

European
Patent Office

Office européen
des brevets

# RAPPORT DE RECHERCHE EUROPEENNE

Numéro de la demande

EP 22 21 4809

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | RUIZHE CAI ET AL: "VIBNN", ARCHITECTURAL SUPPORT FOR PROGRAMMING LANGUAGES AND OPERATING SYSTEMS, ACM, 2 PENN PLAZA, SUITE 701NEW YORKNY10121-0701USA, 19 mars 2018 (2018-03-19), pages 476-488, XP058396877, DOI: 10.1145/3173162.3173212 ISBN: 978-1-4503-4911-6 * Section 4.1 * ----- | 1-15 | |
| A | ANDREW BROCK ET AL: "SMASH: One-Shot Model Architecture Search through HyperNetworks", ARXIV.ORG, CORNELL UNIVERSITY LIBRARY, 201 OLIN LIBRARY CORNELL UNIVERSITY ITHACA, NY 14853, 17 août 2017 (2017-08-17), XP080953384, * Section 3 * ----- | 1-15 | |

**DOMAINES TECHNIQUES RECHERCHES (IPC)**

Le présent rapport a été établi pour toutes les revendications

| Lieu de la recherche | Date d'achèvement de la recherche | Examinateur |
|---|---|---|
| La Haye | 31 mars 2023 | Szymanski, Francois |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...........................................................................
& : membre de la même famille, document correspondant

EPO FORM 1503 03.82 (P04C02)

page 2 de 2